# EUROPEAN PATENT SPECIFICATION

(11) **EP 3 283 270 B1**
(45) Date of publication and mention of the grant of the patent: **15.07.2020**
(21) Application number: 16726945.5
(22) Date of filing: 15.04.2016
(51) Int. Cl.: B29C 48/08, B29C 48/10, B65F 1/14, G06K 19/00, B65F 1/00, G06K 19/02, G06K 19/077, B29C 48/28, B29C 48/00

(54) **PROCESS AND APPARATUS FOR PRODUCING PLASTIC PRODUCTS**
VERFAHREN UND VORRICHTUNG ZUR HERSTELLUNG VON KUNSTSTOFFPRODUKTEN
PROCÉDÉ ET APPAREIL DE PRODUCTION DE PRODUITS EN MATIÈRE PLASTIQUE

(30) Priority: 16.04.2015 IT UD20150050
(43) Date of publication of application: 21.02.2018
(73) Proprietor: TWL Systems SRL, 33100 Udine (IT)
(72) Inventor: GRIFONI, Giorgio, 33031 Basiliano (IT); CHITUSSI, Paolo, 33170 Pordenone (IT)
(74) Representative: Petraz, Davide Luigi
(86) International application number: PCT/IB2016/052174
(87) International publication number: WO 2016/166726

(56) References cited:
- CH-A- 415 033
- FR-A1- 3 001 316
- US-A- 4 417 936
- US-A1- 2006 273 180
- US-A1- 2007 218 227
- SALEEM KHAN ET AL: "Technologies for Printing Sensors and Electronics Over Large Flexible Substrates: A Review", IEEE SENSORS JOURNAL., vol. 15, no. 6, 4 December 2014 (2014-12-04), pages 3164-3185, XP055233792, US ISSN: 1530-437X, DOI: 10.1109/JSEN.2014.2375203
- TONI BJÖRNINEN ET AL: "The Effect of Fabrication Method on Passive UHF RFID Tag Performance", INTERNATIONAL JOURNAL OF ANTENNAS AND PROPAGATION, vol. 1, no. 1, 1 January 2009 (2009-01-01) , pages 1-8, XP055284646, ISSN: 1687-5869, DOI: 10.1109/TMTT.2007.909886

## Description

### FIELD OF THE INVENTION

Embodiments described here concern a method for the production of plastic products and the corresponding production apparatus.

In particular, embodiments described here concern a method for the production of plastic products to make non-rigid containing elements, such as by way of non-restrictive example, wrappings for the food sector, packages, bags for disposing of urban rubbish or other types.

### BACKGROUND OF THE INVENTION

Methods for the production of plastic products for making non-rigid containing elements are known, which provide to make a plastic film by means of an extrusion method. These known methods comprise a first step in which plastic material in granular form is inserted into a tank or container, directly connected to an extrusion head.

Known methods provide a second step, or extrusion step, in which the plastic material is conveyed by thrust means, typically an extrusion screw, from the container to the extrusion head, wherein the extrusion head comprises an exit end, substantially cylindrical in shape. In this second step the material in granular form is heated by heating means of a known type, until it reaches the melting temperature and is then conveyed by said thrust means through a succession of grooves disposed before the extrusion head in order to increase the pressure exerted on the plastic material in its melted form.

The method also provides a third step in which the plastic material is made to exit at high pressure from the extrusion head in the form of a continuous plastic film. In this step, moreover, the extruded plastic material is treated by blowing means of the annular type so as to assume a bubble conformation. Alternatively, the plastic film could be subjected to cast extrusion, that is, extrusion in a flat head.

This known method also provides a fourth step, in which the plastic film thus made is made to pass through one or more rolls in order to cool it, and is subsequently wound on one or more winding rolls to obtain a continuous coil of plastic film, substantially non-rigid.

The method also comprises a printing step in which, by means of printing means disposed between two or more cooling and/or return rolls, a code or identification symbol is printed, generally with ink, for example in predetermined positions of the plastic film, that is, printed to size, said code being for example a numerical or alphanumerical code or a bar code. The printing step can take place simultaneously with the winding step or afterward in an unwinding and cutting step, or die-cutting to size to obtain for example portions of plastic film of limited size intended for subsequent working steps to make the desired plastic products, such as said containing packages or bags. The film made can also be coupled with other materials, for example semi-rigid materials for making containers for liquids, such as milk, fruit juices or other.

One disadvantage of known production methods is that the printing step, being for example of the stereotype or matrix type, does not allow to dynamically introduce printing elements of a variable type, such as serial numbers, numerical or alphanumerical strings able to univocally identify predetermined portions of the plastic film or information relating to the use and content intended to be introduced into the final plastic product, that is, the containing element, during one or more steps of its useful life.

Another disadvantage of known methods is that when the final plastic product has already been made, or has already been used, or is in a state of use, for example it has been put on the market, it is not possible to add to or change the portion already printed with other information.

Methods are also known for printing sensors and electronic components as described by way of example in the document by Khan et al. entitled "Technologies for Printing Sensors and Electronics Over Large Flexible Substrates: A Review". These known methods provide to deposit electrically conductive materials using different printing techniques in order to make electronic sensors and circuits on flexible substrates, such as for example substrates of plastic material. In particular, the methods described in the document in the name of Kahn et al. provide different printing techniques for making printed electronic devices, such as pressure sensors, radiofrequency identification devices (RFID), solar cells, LEDs and transistors.

These known methods are the so-called "roll-to-roll" type, where an entrance reel of the flexible material, made in a previous work step, is progressively unwound, passing through several return rolls in a printing apparatus. The printing apparatus provides to apply one or more of the different printing techniques described in Khan et al. to make sensors and/or the desired circuit portions. The flexible material on which said sensors and/or the desired circuit portions are printed is subsequently re-wound progressively and in coordination with the unwinding speed of the entrance reel in order to obtain a reel at exit from the printing process.

The exit reel is intended for subsequent work steps, for example a cutting or die-cutting step in order to cut to size portions of the substrate and to subsequently apply them on other products, on which the electronic circuits will be used, or a setting and parameterization step, for example to calibrate sensors or to memorize some numerical values or other in the RFID components of the electronic circuits thus made.

However, the printing steps are carried out when the flexible plastic material has already been wound into a reel, and its properties, for example rheology, surface tension, resistance of the material in a longitudinal direction and a transverse direction or others, are defined during the production process by extrusion and are no longer modifiable. Furthermore, these properties, such as for example the surface tension, change with time and if the printing step takes place several weeks after the production of the reel of plastic material, it is necessary to provide a setting and/or specific calibration to select the most suitable printing material for the properties of the plastic material when said plastic material is worked. This makes it necessary to adapt the printing material, for example selecting the type of conductive or insulating ink, according to the specific properties of the substrate of plastic material. The time required for equipping the printing apparatuses can be rather long, therefore increasing the production costs of the flexible plastic material. Furthermore, if it is necessary to significantly change the composition of the printing materials to be deposited, the tolerance of the electric properties of the circuit portions made, for example resistance or surface conductivity of the material deposited, can in turn deviate significantly from predetermined design values.

Documents US-A-2007/218227, FR-A-3.001.316, US-A-2006/273180, CH-A-415.0333 and US-A-4,417,936 are also known.

There is therefore a need to perfect a method for the production of plastic products, a corresponding production apparatus and the plastic products thus made, which can overcome at least one of the disadvantages of the state of the art.

In particular, one purpose of the present invention is to obtain a method for the production of plastic products that allows to associate desired information, both predetermined and dynamic, with each product made.

Another purpose of the present invention is to obtain a method for the production of plastic products to make non-rigid containing elements which allows to reduce the cost of production, management, storage, conservation and recycling of the plastic products and/or the objects intended to be contained inside the containing elements.

Another purpose of the present invention is to obtain a method for the production of plastic products that allows to reduce setting and parameterization times for possible other work steps, depending on the specific properties of the plastic material produced.

The present disclosure also concerns a plastic product for making non-rigid containing elements which allows to reduce the environmental impact of their management or the management of the life cycle of the objects to be inserted in the containing elements.

Another purpose of the present invention is to make an apparatus for the production of plastic products with which it is possible to associate desired information, both predetermined and dynamic.

Another purpose of the present invention is to make an apparatus for the production of plastic products which allows to reduce the equipping times for further work steps on said plastic products.

Other limitations and disadvantages of conventional solutions and technologies will be clear to a person of skill after reading the remaining part of the present description with reference to the drawings and the description of the embodiments that follow, although it is clear that the description of the state of the art connected to the present description must not be considered an admission that what is described here is already known from the state of the prior art.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purposes, embodiments described here concern a method for the production of plastic products to make non-rigid containing elements. In accordance with one embodiment, the method comprises a loading step in which plastic material in granular form is inserted in a containing element.

The method also comprises a heating step, in which the plastic material in granular form is heated by heating means associated with the containing element until the melting temperature is reached.

The method also comprises an extrusion step in which the plastic material is conveyed toward extrusion means and extruded to form at least one layer of film of plastic material

The method also comprises a printing step in which, by means of printing means, at least one layer of printing material is deposited on the film of plastic material to define information associated with the film of plastic material or to the use of the containing elements made with the plastic film.

According to the present invention, during the printing step the printing means deposit electrically conductive material on the film of plastic material, arriving continuously from the extrusion step, the conductive material being deposited according to a predetermined and desired conformation able to define a predetermined electric circuit. Moreover, the electric circuit comprises at least electronic memorization means configured to memorize information associated with the type of containing element to be made.

In this way it is possible to memorize different information, both predetermined and dynamic, relating to the type of plastic product, for example to the composition of the plastic material itself, to the date of production or to the type of object that will be inserted into the containing elements. Merely by way of non-restrictive example, the present invention allows to make bags for rubbish provided with a memory in which even before its use the type of rubbish to be contained is memorized, or subsequently and during its use the details of the specific user who uses the bag can be memorized. Therefore in the case of containing elements made according to the present invention, it is possible to apply a precise and fair tariff for the management and recycling of solid urban waste.

The present invention can also be used to make containing elements for use in the food sector, allowing to memorize specific information both before the products destined to be contained in the bags are introduced, and also at the same time the products are inserted into the bags, and also during their use. By way of example the information can contain data relating to the "best-by" date, the actual expiry date, depending on the actual conservation of the foodstuff in the distribution chain, the ingredients, allergen components, anti-infringement codes or other.

According to another variant of the present invention, during the printing step a passively fed electric circuit is made.

In a preferential embodiment the electric circuit comprises at least one RFID (Radio Frequency Identifier) tag.

According to another aspect of the invention, the electrically conductive material comprises material of the biodegradable type. In this way, the bags, in this case those for rubbish, can be disposed of without exacerbating the environmental impact.

In accordance with another embodiment, the printing step is carried out immediately after the extrusion step.

In accordance with another embodiment, the method provides a step of winding the film onto one or more reels, the printing step being carried out after the extrusion step and before the winding step.

According to yet another embodiment, the method provides a step of drawing and stretching the film after the extrusion step, the printing step being carried out after the drawing and stretching step.

Advantageously, carrying out the printing immediately after the extrusion of the film, and possibly the drawing and stretching step, in any case before the possible winding onto a reel, allows to deposit the conductive material on the film which has just been extruded that is still at a relatively high temperature, that is, it is still hot, in order that the depositing and printing of the conductive material achieves a stable and reliable coupling between extruded "hot" plastic material and conductive material.

The present disclosure also concerns a plastic product for non-rigid containing elements, such as wrappings, bags or other, comprising at least one layer of plastic film, wherein the layer of plastic film comprises a printed portion in which information relating to the plastic film itself or to the use of the plastic products made by the plastic film in subsequent steps is associated.

The printed portion comprises electrically conductive material, having a predetermined conformation defining a predetermined electric circuit, said electric circuit comprising at least electronic memorization means configured to memorize at least information associated with the type of containing element to be made.

It is a variant to provide that the electric circuit is the passive feed type.

In a preferential embodiment the electric circuit comprises at least an RFID (Radio Frequency Identifier) tag.

The electrically conductive material may comprise material of the biodegradable type.

In accordance with another embodiment, the layer of plastic film is extruded and the printed portion is formed by conductive material deposited on the film of plastic material arriving continuously from the extrusion step.

The present invention also concerns an apparatus for the production of plastic products such as non-rigid containing elements, like bags, wrappings or other. The apparatus according to the present invention comprises heating means configured to heat and melt plastic material in granular form. The apparatus also comprises extrusion means, associated with the heating means, configured to extrude the melted plastic material in order to form at least a layer of film of plastic material. The apparatus also comprises printing means configured to deposit on the film of plastic material at least one layer of printing material to define information associated with the plastic film itself or with the use of the containing elements made with the plastic film.

According to one aspect of the present invention, the printing means are configured to deposit electrically conductive material on the plastic film according to a predetermined and desired conformation able to define a predetermined electric circuit. The printing means comprise forming means configured to deposit the electrically conductive material to make at least electronic memorization means in the electric circuit.

According to another variant of the present invention, the forming means are configured to deposit electrically conductive material of the biodegradable type.

According to another variant of the present invention, the apparatus according to the present invention comprises writing/reading means configured to cooperate with the memorization means to memorize predetermined information therein. For example, the information to be memorized is associated to the type of plastic product to be made or to the type of objects to be inserted in the containing elements.

In accordance with one aspect of the invention, the printing means are disposed immediately after the extrusion means.

In accordance with other embodiments, the apparatus comprises reels to wind the film downstream of the extrusion means, the printing means being disposed after the extrusion means and before the one or more winding reels.

In accordance with other embodiments which are not part of the invention, the apparatus comprises stretching means configured to stretch the film and disposed after the extrusion means, the printing means being disposed after the stretching means.

These and other aspects, characteristics and advantages of the present disclosure will be better understood with reference to the following description, drawings and attached claims. The drawings, which are integrated and form part of the present description, show some embodiments of the present invention, and together with the description, are intended to describe the principles of the disclosure.

The various aspects and characteristics described in the present description can be applied individually where possible. These individual aspects, for example aspects and characteristics described in the description or in the attached dependent claims, can be the object of divisional applications.

It is understood that any aspect or characteristic that is discovered, during the patenting process, to be already known, shall not be claimed and shall be the object of a disclaimer.

### BRIEF DESCRIPTION OF THE DRAWINGS

These and other characteristics of the present invention will become apparent from the following description of a preferential embodiment, given as a non-restrictive example with reference to the attached drawings wherein:

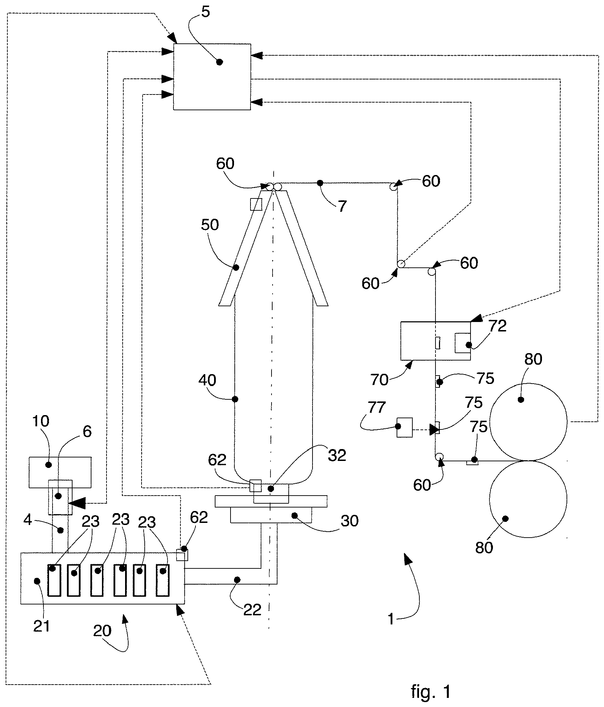

- fig. 1 is a schematic representation of the method for the production of plastic products according to the present invention.

To facilitate comprehension, the same reference numbers have been used, where possible, to identify identical common elements in the drawings. It is understood that elements and characteristics of one embodiment can conveniently be incorporated into other embodiments without further clarifications.

### DETAILED DESCRIPTION OF SOME EMBODIMENTS

We shall now refer in detail to the various embodiments of the present invention, of which one or more examples are shown in the attached drawings. Each example is supplied by way of illustration of the invention and shall not be understood as a limitation thereof. For example, the characteristics shown or described insomuch as they are part of one embodiment can be adopted on, or in association with, other embodiments to produce another embodiment. It is understood that the present invention shall include all such modifications and variants.

Before describing these embodiments, we must also clarify that the present description is not limited in its application to details of the construction and disposition of the components as described in the following description using the attached drawings. The present description can provide other embodiments and can be obtained or executed in various other ways. We must also clarify that the phraseology and terminology used here is for the purposes of description only, and cannot be considered as limitative.

With reference to the attached drawings, a method for the production of plastic products according to embodiments described here can be used in a continuous production line for plastic films for making non-rigid containers, such as for example bags for containing food products, packing bags, bags for disposing of urban waste.

In particular, in the case of bags for disposing of solid urban waste, the plastic material used can be the biodegradable type. The bags made using the method described here comprise an RFID tag 75, and can be used in the differentiated disposal of waste, associating each bag with an actual user, allowing to precisely record the quantity of waste disposed of.

With reference to fig. 1, the method for the production of plastic products according to embodiments described here can provide to use an apparatus 1 comprising:
- heating means 23 configured to heat and melt plastic material in granular form,
- extrusion means, hereafter also called extruder 20, associated with the heating means 23, configured to extrude the melted plastic material in order to form at least a layer of film 40 of plastic material,
- printing means, hereafter also called printer 70, configured to deposit on the film 40 of plastic material at least one layer of printing material to define information associated with the plastic film itself or with the use of the containing elements made with the plastic film.

In possible implementations, the extruder 20 can be a bubble extruder.

In other possible implementations, the extruder 20 can be an extruder with a flat head (cast extrusion).

The printer 70 is disposed immediately after the extruder 20.

In possible implementations, the apparatus 1 can include reels 80 for winding the film 40 downstream of the extruder 20, said printer 70 being disposed after the extruder 20 and before the one or more winding reels 80.

In possible implementations, the apparatus 1 can also include drawing and stretching means, also called stretching unit 50, configured to draw and stretch the film 40 and disposed after the extruder 20. In particular, the stretching unit 50 can be configured to draw and stretch the extruded film. For example, the stretching unit 50 can be the oscillating type. In possible implementations, the stretching unit 50 can include drawing and stretching rolls. Furthermore, the stretching unit 50 can have cooled rolls depending on the characteristics to be imparted to the film. In possible implementations, for example in particular in the case of bubble extrusion, the stretching unit can be a so-called tip roller.

In possible implementations, the apparatus 1 can include a control and processing unit 5, a measurer 6, a loading hopper 10, the extruder 20, the stretching unit 50, rolls 60, the printer 70 and one or more of the winding reels 80.

In some embodiments, the method provides a first step, or loading step, in which plastic material in granular form is inserted inside the feed or loading hopper 10. The material is introduced into the hopper 10 which is in turn connected to the measurer 6, of a known type and not described any further here. The measurer 6 releases the desired quantity and measure of plastic material according to the commands received from the control and processing unit 5 as will be described in more detail hereafter. The hopper 10 is connected by means of a first tubular pipe 4, or feed pipe, to the extruder 20.

The method provides a second step in which the plastic material in granular form unloaded inside the extruder 20 is heated. Indeed, the extruder 20 comprises a heating chamber 21 provided with heat resistances 23 by means of which the plastic material is heated until it reaches the melting temperature. The extruder 20 also comprises mechanical conveyors associated with the heating chamber 21, of a known type and not shown, and an extrusion head 30, connected to the heating chamber 21 by means of a second pipe 22. The plastic material in melted form is thrust at high pressure, by means of a screw (not shown), toward the extrusion head 30.

The method also comprises an extrusion step in which the plastic material in melted form is made to exit at high pressure from the extrusion head 30 to form a film 40, substantially non-rigid. The extrusion head 30 is also provided with an air ring 32, which has a circular shape and is suitable to emit air to cool the plastic material exiting. The air ring 32 allows to make the melted plastic material come out in the form of a film 40 with a bubble conformation and subsequently to convey it toward the stretching unit 50. In possible embodiments, the method provides a step of drawing and stretching the film 40 using the stretching unit 50, after the extrusion step.

The film 40 is then made to advance through a succession of cooling rolls 60, disposed so as to keep the film 40 always in predetermined tension conditions.

The production method, according to an embodiment which is not part of the invention, also comprises a printing step in which the film 40 of plastic material is made to pass in correspondence with the printer 70, interposed between two adjacent rolls 60, so as to deposit the printing material on a surface portion of the film 40 in desired tension conditions and to conform a flat portion of film 40 on which to print. Therefore, for example, the printing step using the printer 70 can be carried out after the drawing and stretching step done with the stretching unit 50. It is understood that the printer 70 can be disposed in any other suitable position in the production line of the plastic film.

During the printing step, the printer 70 deposits in predetermined positions on the surface of the film 40, and in coordination with the feed of the film 40, one or more layers of electrically conductive material and one or more layers of electric insulating material in a desired conformation and so as to obtain a predetermined electric circuit comprising the RFID tag 75. In particular the printer 70 deposits both a first portion of electrically conductive material to obtain the antenna of the RFID tag 75 and also a second portion of electric circuit to obtain a non-volatile memory of the RFID tag 75.

In particular, the printer 70 comprises forming means, such as for example a photolithographic mask 72, by means of which the electrically conductive material is deposited on the film 40 of plastic material according to a predetermined electric topography such as to obtain the configuration of the RFID tag 75, in this case both the antenna and the non-volatile memory.

It is understood that the printing step can be carried out by any other known printing technique, such as for example described in the document "Technologies for Printing Sensors and Electronics Over Large Flexible Substrates: A Review" by Khan et al. For example the conductive material can be deposited by silk screen printing techniques, ink jet or slot-die printing.

In one embodiment of the present invention, the electrically conductive material comprises biodegradable material, such as for example magnesium. In this way the bag made is completely biodegradable and recyclable, making the invention particularly suitable for use in the disposal of all types of urban waste, and in particular wet urban waste or compost.

The control and processing unit 5 controls the measurer 6, the extruder 20 and the printer 70 to make the film 40 come out of the stretching unit 50, in coordination with the speed of feed of the film 40 in the apparatus 1. In fact, the printing and depositing speed of the printer 70 is regulated according to the speed of feed of the film 40 itself, and vice versa. The apparatus 1 comprises one or more speed sensors of the known type (not shown in the drawings), for example a rotation encoder, associated with at least one of the rolls 60 and/or the reels 80 and suitable to measure continuously the speed of feed of the film 40. The encoders are connected to the control and processing unit 5 to detect continuously the speed of feed of the film 40 at different points of the apparatus 1. The control and processing unit 5 can in this way verify that the speed of feed of the film 40 and the printing speed of the printer 70 are as established. Therefore, the control and processing unit 5 sends to the measurer 6 the measuring commands so as to determine the delivery of a type and quantity of granular plastic material such as to guarantee the production and exit of the film 40 from the stretching unit 50 with pre-set rheological properties and transverse and longitudinal surface tension and at a speed coordinated to the printing speed.

It is understood that the encoder can in turn be associated with an electronic feedback circuit of a known type (not shown), and directly connected to the printer 70 or the control and processing unit 5 and such as to adjust the printing or depositing speed of the electric material of the printer 70 according to the value of speed of feed of the film 40 as detected by the encoders.

The apparatus 1 also comprises temperature sensors 62 disposed in different positions, to continuously detect the temperature at different points of the line, for example of the heating chamber 21 and the extrusion head 30. The temperature sensors 62 are connected to the control and processing unit 5 to send feedback data of the process to it, together with the data arriving from the speed sensors.

The apparatus 1 also comprises pressure sensors, typically associated with the extruder 20, of a known type and not shown here, which are connected to the control and processing unit 5 and detect the pressure value inside the extruder 20.

Based on the temperature values detected in the apparatus 1, the pressure values in the extruder 20, the value detected of the speed of feed of the film 40 and the specific properties of the plastic film to be obtained, the control and processing unit 5 controls the measurer 6, the resistances 23 and the printer 70 so as to determine the exit of the film 40 from the stretching unit 50, and the depositing by the printer 70 of the conductive material in order to make the tags 75.

By way of non-restrictive example, in order to deposit ink of conductive material with a PEDOT base on a film obtained starting from an LDPE type resin, so as to obtain an accurate and precise deposit of the conductor tracks and with desired thicknesses, in the range of about ten micrometers, the control and processing unit 5 adjusts and corrects the parameters of the production line substantially continuously. In the case of a film consisting of an external layer comprising metallocene-polyethylene resin with a melt index (at 190°C, 2.16 kg) equal to 1.3-1.4g/10min, the percentage of PEDOT that makes up the ink is in a range that goes from 13% to 26%. In particular, to obtain a film 40 that has a predetermined coefficient of ultimate elongation, measured in percentage unit as a parameter of the ISO test method, resistance to tearing, measured in N/mm as a parameter of the ISO test methods, and resistance to impact, measured in grams as a parameter of the ISO test method, the control unit 5 must precisely adjust the composition of the film 40. In particular the control unit 5 acts on the measurer 6 to release a desired quantity and mixture of plastic material in granular form to the extruder 20. The control unit 5 also detects, as already described above, the speed of feed of the film 40 by the speed detectors, the process temperature by the temperature sensors 62, the environmental temperature by means of corresponding temperature sensors (not shown) and the pressure in the extruder 20. The control unit 5 also detects, in a known manner, the surface tension of the film, measured in dynes.

The deposit of the conductive material in order to make the RFID tags 75 during the production of the plastic film 40 allows to control precisely both the thickness of the tags deposited and also, possibly, to at least partly drown the tags inside the film, as the deformability of the plastic film 40 can be exploited during production. In this way it is possible to prevent problems of overlapping of the tags 75 in the subsequent winding step, reducing to a minimum the thickness tolerances required.

Furthermore, seeing that the production process of a plastic film by extrusion is a process that, given the same polymer material used, depends on the working conditions and on specific additives used during working, in the method according to the present invention the depositing of the RFID tags 75 made directly in the production line of the plastic film allows for example to modify the color and transparency of the plastic film itself in combination with the specific tags. In the known methods of the "roll-to-roll" type, this is not possible because the film has already been made and the properties can no longer be modified.

It is understood that the direct depositing of tags 75 on plastic films during the production process of the films 40 allows to reduce the times needed to select both the printing materials, for example the inks in the case of ink-jet printing, and the specific composition of the polymers. In fact, said selection and composition operations can be carried out during the equipping of the line, verifying that the properties of the film produced are in conformity with those predetermined.

In one embodiment of the present invention, not shown in the attached drawings, the printer of the ink-jet type comprises at least two printing cartridges, a first cartridge intended to contain conductive ink and a second cartridge to contain insulating ink. In another embodiment, the printer 70 comprises two or more delivery cartridges and as many ink mixers in which the mixers take the components to generate respectively conductive inks and insulating inks to be deposited on the plastic film 40 according to its specific properties. In this way it is possible to modify in real time the specific composition of the printing materials, that is, of the inks, according to the specific composition of the plastic film 40 produced, since the control and processing unit 5 can act simultaneously both on the parameters of the extruder 20, as described before, and also on the mixing of the conductive and insulating inks.

The method then comprises a memorization step in which, by means of an RFID tag reader/writer 77, disposed near the printer 70 and advantageously connected to a control unit, such as a personal computer, not shown in the drawings, on each RFID tag 75 of the film 40 during the feed step, predetermined information is memorized, such as for example the type of bag that will be produced, its intended use, a unique serial number that univocally identifies each bag produced using the present method. In this way it is possible to produce rubbish bags that can be associated with the final user and to memorize additional information in the RFID tag 75, also at a later time, such as the identity of the user and hence obtain an association between the specific bag and the user. This allows for example in the case where the bags produced with the method according to the present invention are used for the disposal of solid urban waste, to precisely record the quantity of waste produced, associating it with the specific user.

For example, if the plastic film 40 is intended for making bags for the food sector, it is possible to memorize in the RFID tags 75 information relating to the date of production of the film, the producer of the food products, the duration of the film or the type of food compatible with the plastic film.

It is understood that the tag reader/writer 77 can be incorporated in the printer 70, or that it can be disposed in another position of the apparatus 1 for the production of plastic products according to the present invention.

In one embodiment of the method according to the present invention, the tag reader/writer 77 only controls the presence of the RFID tag 75 on the film 40 or possibly on the finished bag. In this way it is possible to verify the correct printing of the RFID tag 75 on every portion of film 40 or on every bag thus produced.

The method also comprises a winding step in which the film 40 on which the RFID tags 75 are printed is wound onto a reel 80 to then be sent to subsequent work steps in one of which the film 40 wound on the reel 80 is for example die-cut or cut to size, and in coordination with the positions of the RFID tags 75 printed on the film 40 to obtain the bags. According to one embodiment, not shown here, the method does not include the winding step, but a direct step of cutting or die-cutting, in which the film is cut or die-cut to size after the RFID tag 75 has been deposited and made available as a finished product. In this case it is obvious that the production costs of the containing elements are considerably reduced, since no further winding steps are required.

It is understood that the method according to the present invention can also provide a step of treating the plastic film 40, to facilitate the adhesion of the printing material. For example, the method can provide a known step, not further described here, of crown or plasma treatment, performed before the printing material has been deposited in order to increase the intrinsic surface energy of the plastic film 40.

It is clear that modifications and/or additions of parts may be made to the apparatus 1 and the method for the production of plastic products and the plastic products as described heretofore, without departing from the field and scope of the present invention.

For example, it comes within the field of the present invention to provide that the memorization means comprise an NFC (Near Field Communication) chip or other type of semi-conductor circuit of the wireless type, and passive, fed by an electromagnetic field interacting with the memorization means deposited on the film 40 of plastic material.

It also comes within the field of the present invention to provide that the printer 70 deposits electrically conductive material so as to obtain other circuit components, such as for example a weight measurer or an extensometer. In this way, if the bags are used for rubbish disposal, with the bags made with the film 40 of plastic material according to the present invention it is possible not only to memorize the specific user and the type of waste disposed of, but also to calculate the corresponding weight, or possibly the volume, thus facilitating the operations to manage and charge for the waste.

It is clear that modifications and/or additions of parts and/or steps may be made to the method for the production of plastic products, the corresponding production apparatus and the plastic products thus obtained as described heretofore, without departing from the field and scope of the present invention as defined by the claims.

It is also clear that, although the present invention has been described with reference to some specific examples, a person of skill in the art shall certainly be able to achieve many other equivalent forms of the method for the production of plastic products, the corresponding production apparatus and the plastic products thus obtained, having the characteristics as set forth in the claims and hence all coming within the field of protection defined thereby.

In the following claims, the sole purpose of the references in brackets is to facilitate reading: they must not be considered as restrictive factors with regard to the field of protection claimed in the specific claims.

## Claims

1. Method for the production of plastic products comprising:
- a loading step in which plastic material in granular form is inserted in a containing element (10),
- a heating step, in which said plastic material in granular form is heated by heating means (23) associated with said containing element (10) until the melting temperature is reached,
- an extrusion step in which said plastic material is conveyed toward extrusion means (30) and extruded to form at least one layer of film (40) of plastic material,
- a printing step in which, by means of printing means (70), at least one layer of printing material is deposited on said film (40) to define information associated with said film (40) of plastic material,
**characterized in that** during said printing step the printing means (70) deposit conductive material on said film of plastic material (40), arriving continuously from said extrusion step, said conductive material being deposited according to a predetermined and desired conformation able to define a predetermined electric circuit, said electric circuit comprising at least electronic memorization means (75) configured to memorize at least information associated with the type of plastic product to be made.

2. Method as in claim 1, **characterized in that** in said printing step a passively fed electric circuit is made.

3. Method as in claim 1 or 2, **characterized in that** said electrically conductive material comprises material of a biodegradable type.

4. Method as in any of the claims from 1 to 3, **characterized in that** said printing step is carried out immediately after the extrusion step.

5. Method as in any of the claims from 1 to 4, **characterized in that** said method provides a step of winding the film (40) onto one or more reels (80), said printing step being carried out after the extrusion step and before said winding step.

6. Method as in any of the claims from 1 to 5, **characterized in that** said method provides a drawing and stretching of the film (40) after the extrusion step, said printing step being carried out after the drawing and stretching step.

7. Apparatus for the production of plastic products, such as non-rigid containing elements, comprising:
- heating means (23) configured to heat and melt plastic material in granular form,
- extrusion means (20), associated with said heating means (23), configured to extrude the melted plastic material in order to form a layer of film (40) of plastic material,
- printing means (70) configured to deposit on said film (40) of plastic material at least one layer of printing material to define information associated with the plastic film itself or with the use of the containing elements made with said plastic film,
**characterized in that** said printing means (70) are configured to deposit electrically conductive material on said plastic film (40), arriving continuously from said extrusion means (20), according to a predetermined and desired conformation able to define a predetermined electric circuit, said printing means (70) comprising forming means (72) configured to deposit said electrically conductive material to make at least electronic memorization means (75) in said electric circuit, wherein said printing means (70) are disposed immediately after the extrusion means (20).

8. Apparatus as in claim 7, **characterized in that** said printing means (70) are configured to deposit electrically conductive material of the biodegradable type.

9. Apparatus as in either of claims 7 or 8, **characterized in that** it comprises writing/reading means (77) configured to cooperate with said memorization means (75) to memorize and/or read predetermined information, said information being associated with the type of plastic product to be made or with the type of objects to be inserted in said containing elements.

10. Apparatus as in any of the claims from 7 to 9, **characterized in that** said apparatus comprises reels (80) for winding the film (40) downstream of the extrusion means (20), said printing means (70) being disposed after the extrusion means (20) and before said one or more winding reels (80).

11. Apparatus as in any of the claims from 7 to 10, **characterized in that** said apparatus comprises stretching means (50) configured to draw and stretch the film (40) and disposed after the extrusion means (20), said printing means (70) being disposed after said stretching means (50).

## Patentansprüche

1. Verfahren zur Produktion von Kunststoffprodukten, aufweisend:
- einen Ladeschritt, in welchem Kunststoffmaterial in granulöser Form in ein Behälterelement (10) einbracht wird,
- einen Erwärmschritt, in welchem das Kunststoffmaterial in granulöser Form durch Heizmittel (23), die mit dem Behälterelement (10) verknüpft sind, erwärmt wird bis die Schmelztemperatur erreicht wird,
- einen Extrudierschritt, in welchem das Kunststoffmaterial zu Extrudiermitteln (30) hin transportiert wird und extrudiert wird, um wenigstens eine Filmschicht (40) aus Kunststoffmaterial zu bilden,
- einen Druckschritt, in welchem durch Druckmittel (70) wenigstens eine Schicht Druckmaterial auf dem Film (40) abgelagert wird, um Informationen zu definieren, die mit dem Film (40) aus Kunststoffmaterial verknüpft sind,
**dadurch gekennzeichnet, dass** während des Druckschritts die Druckmittel (70) leitfähiges Material auf dem Film aus Kunststoffmaterial (40) ablagern, der kontinuierlich von dem Extrudierschritt ankommt, wobei das leitfähige Material gemäß einer vorbestimmten und gewünschten Konstellation abgelagert wird, die imstande ist, einen vorbestimmten elektrischen Schaltkreis zu definieren, wobei der elektrische Schaltkreis wenigstens elektronische Speichermittel (75) aufweist, die konfiguriert sind, um wenigstens Information zu speichern, die mit dem Typ von herzustellendem Kunststoffprodukt verknüpft sind.

2. Verfahren gemäß Anspruch 1, **dadurch gekennzeichnet, dass** im Druckschritt ein passiv gespeister elektrischer Schaltkreis erstellt wird.

3. Verfahren gemäß Anspruch 1 oder 2, **dadurch gekennzeichnet, dass** das elektrisch leitfähige Material aufweist Material von einem bioabbaubaren Typ.

4. Verfahren gemäß irgendeinem der Ansprüche 1 bis 3, **dadurch gekennzeichnet, dass** der Druckschritt unmittelbar nach dem Extrudierschritt durchgeführt wird.

5. Verfahren gemäß irgendeinem der Ansprüche 1 bis 4, **dadurch gekennzeichnet, dass** das Verfahren aufweist einen Schritt des Windens des Films (40) auf eine oder mehrere Rollen (80), wobei der Druckschritt durchgeführt wird nach dem Extrudierschritt und von dem Windenschritt.

6. Verfahren gemäß irgendeinem der Ansprüche 1 bis 5, **dadurch gekennzeichnet, dass** das Verfahren bereitstellt ein Ziehen und Dehnen des Films (40) nach dem Extrudierschritt, wobei der Druckschritt durchgeführt wird nach dem Ziehen- und Dehnenschritt.

7. Vorrichtung zur Produktion von Kunststoffprodukten, wie nicht-starren Behälterelementen, aufweisend:
- Heizmittel (23), die konfiguriert sind, um Kunststoffmaterial in granulöser Form zu erwärmen und zu schmelzen,
- Extrudiermittel (20), die mit den Heizmitteln (23) verknüpft sind und die konfiguriert sind, um das geschmolzene Kunststoffmaterial zu extrudieren, um eine Filmschicht (40) aus Kunststoffmaterial zu bilden,
- Druckmittel (70), die konfiguriert sind, um auf dem Film (40) aus Kunststoffmaterial wenigstens eine Schicht Druckmaterial abzulagern, um Informationen zu definieren, die mit dem Kunststofffilm seinerseits oder mit der Verwendung der mit dem Kunststofffilm erstellten Behälterelemente verknüpft sind,
**dadurch gekennzeichnet, dass** die Druckmittel (70) konfiguriert sind, um elektrisch leitfähiges Material auf dem Kunststofffilm (40), der kontinuierlich von den Extrudiermitteln (20) ankommt, abzulagern gemäß einer vorbestimmten und gewünschten Konstellation, die imstande ist, einen vorbestimmten elektrischen Schaltkreis zu definieren, wobei die Druckmittel (70) aufweisen Formmittel (72), die konfiguriert sind, um das elektrisch leitfähige Material abzulagern, um wenigstens elektronische Speichermittel (75) in dem elektrischen Schaltkreis zu erstellen, wobei die Druckmittel (70) unmittelbar nach den Extrudiermitteln (20) angeordnet sind.

8. Vorrichtung gemäß Anspruch 7, **dadurch gekennzeichnet, dass** die Druckmittel (70) konfiguriert sind, um elektrisch leitfähiges Material vom bioabbaubaren Typ abzulagern.

9. Vorrichtung gemäß Anspruch 7 oder 8, **dadurch gekennzeichnet, dass** sie aufweist Schreib-/Lese-Mittel (77), die konfiguriert sind, um mit den Speichermitteln (75) zusammenzuwirken, um vorbestimmte Informationen zu speichern und/oder zu lesen, wobei die Informationen verknüpft sind mit dem Typ des herzustellenden Kunststoffprodukts oder mit dem Typ der in die Behälterelemente einzubringenden Objekte.

10. Vorrichtung gemäß irgendeinem der Ansprüche 7 bis 9, **dadurch gekennzeichnet, dass** die Vorrichtung Rollen (80) zum Aufwinden des Films (40) aufweist, die den Extrudiermitteln (20) nachgeschaltet sind, wobei die Druckmittel (70) nach den Extrudiermitteln (20) und vor der einen oder mehreren Rollen (80) angeordnet sind.

11. Vorrichtung gemäß irgendeinem der Ansprüche 7 bis 10, **dadurch gekennzeichnet, dass** die Vorrichtung Dehnmittel (50) aufweist, die konfiguriert sind, um den Film (40) zu ziehen und zu dehnen, und die nach den Extrudiermitteln (20) angeordnet sind, wobei die Druckmittel (70) nach den Dehnmitteln (50) angeordnet sind.

## Revendications

1. Méthode de fabrication de produits en plastique comprenant :
- une étape de chargement dans laquelle une matière plastique sous forme granulaire est insérée dans un élément de confinement (10),
- une étape de chauffage, dans laquelle ladite matière plastique sous forme granulaire est chauffée par des moyens de chauffage (23) associés audit élément de confinement (10) jusqu'à ce que la température de fusion soit atteinte,
- une étape d'extrusion dans laquelle ladite matière plastique est transportée vers des moyens d'extrusion (30) et extrudée pour former au moins une couche de film (40) de matière plastique,
- une étape d'impression dans laquelle, au moyen de moyens d'impression (70), au moins une couche de matériau d'impression est déposée sur ledit film (40) pour définir des informations associées audit film (40) de matière plastique,
**caractérisée en ce que** lors de ladite étape d'impression, les moyens d'impression (70) déposent du matériau conducteur sur ledit film de matière plastique (40), arrivant en continu de ladite étape d'extrusion, ledit matériau conducteur étant déposé selon une conformation prédéterminée et souhaitée apte à définir un circuit électrique prédéterminé, ledit circuit électrique comprenant au moins des moyens de mémorisation électroniques (75) configurés pour mémoriser au moins des informations associées au type de produit en plastique à fabriquer.

2. Méthode selon la revendication 1, **caractérisée en ce que** dans ladite étape d'impression, un circuit électrique alimenté passivement est réalisé.

3. Méthode selon la revendication 1 ou 2, **caractérisée en ce que** ledit matériau électriquement conducteur comprend un matériau d'un type biodégradable.

4. Méthode selon l'une quelconque des revendications 1 à 3, **caractérisée en ce que** ladite étape d'impression est effectuée immédiatement après l'étape d'extrusion.

5. Méthode selon l'une quelconque des revendications 1 à 4, **caractérisée en ce que** ladite méthode prévoit une étape d'enroulement du film (40) sur une ou plusieurs bobines (80), ladite étape d'impression étant effectuée après l'étape d'extrusion et avant ladite étape d'enroulement.

6. Méthode selon l'une quelconque des revendications 1 à 5, **caractérisée en ce que** ladite méthode prévoit un tirage et un étirage du film (40) après l'étape d'extrusion, ladite étape d'impression étant effectuée après l'étape de tirage et d'étirage.

7. Appareil pour la production de produits en plastique, tels que des éléments de confinement non rigides, comprenant :
- des moyens de chauffage (23) configurés pour chauffer et faire fondre une matière plastique sous forme granulaire,
- des moyens d'extrusion (20), associés auxdits moyens de chauffage (23), configurés pour extruder la matière plastique fondue afin de former une couche de film (40) de matière plastique,
- des moyens d'impression (70) configurés pour déposer sur ledit film (40) de matière plastique au moins une couche de matériau d'impression pour définir des informations associées au film de plastique lui-même ou à l'utilisation des éléments de confinement réalisés avec ledit film de plastique,
**caractérisé en ce que** lesdits moyens d'impression (70) sont configurés pour déposer un matériau électriquement conducteur sur ledit film de plastique (40), arrivant en continu desdits moyens d'extrusion (20), selon une conformation prédéterminée et souhaitée capable de définir un circuit électrique prédéterminé, lesdits moyens d'impression (70) comprenant des moyens de formation (72) configurés pour déposer ledit matériau électriquement conducteur pour réaliser au moins des moyens de mémorisation électroniques (75) dans ledit circuit électrique, dans lequel lesdits moyens d'impression (70) sont disposés immédiatement après les moyens d'extrusion (20).

8. Appareil selon la revendication 7, **caractérisé en ce que** lesdits moyens d'impression (70) sont configurés pour déposer un matériau électriquement conducteur du type biodégradable.

9. Appareil selon l'une des revendications 7 ou 8, **caractérisé en ce qu'**il comprend des moyens d'écriture/lecture (77) configurés pour coopérer avec lesdits moyens de mémorisation (75) pour mémoriser et/ou lire des informations prédéterminées, lesdites informations étant associées au type de produit en plastique à réaliser ou au type d'objets à insérer dans lesdits éléments de confinement.

10. Appareil selon l'une quelconque des revendications 7 à 9, **caractérisé en ce que** ledit appareil comprend des bobines (80) pour enrouler le film (40) en aval des mayens d'extrusion (20), lesdits moyens d'impression (70) étant disposés après les moyens d'extrusion (20) et avant lesdites une ou plusieurs bobines d'enroulement (80).

11. Appareil selon l'une quelconque des revendications 7 à 10, **caractérisé en ce que** ledit appareil comprend des moyens d'étirage (50) configurés pour tirer et étirer le film (40) et disposés après les moyens d'extrusion (20), lesdits moyens d'impression (70) étant disposés après lesdits moyens d'étirage (50).
